# EUROPEAN PATENT APPLICATION

(11) **EP 2 180 500 A1**
(43) Date of publication of application: **28.04.2010**
(21) Application number: 08167571.2
(22) Date of filing: 24.10.2008
(51) Int. Cl.: H01J 37/34, C23C 14/34

(54) **Rotatable sputter target backing cylinder, rotatable sputter target, methods of producing and restoring a rotatable sputter target, and coating installation**

(71) Applicant: Applied Materials, Inc., Santa Clara, CA 95054 (US)
(72) Inventor: Schaefer, Michael, 63674 Altenstadt (DE); Trassl, Roland, 35392 Gießen (DE); Liu, Jian, 63538 Großkrotzenburg (DE)
(74) Representative: Zimmermann & Partner

(57) **Abstract**

A rotatable target base device for sputtering installations is provided, wherein the target base device is adapted for receiving thereon a solid target cylinder, the rotatable target base device comprising a target base cylinder (4) having a lateral surface (3), a middle part (12), a first end region (7) and a second end region (9) opposite to the first end region, wherein at least one of the first and the second end regions has a maximum outer diameter substantially equal to or less than an outer diameter of the middle part.

## Description

### FIELD OF THE INVENTION

Embodiments of the invention generally relate to sputtering installations. More particularly, they relate to a rotatable target base device, a rotatable target, a method for producing a rotatable target, a method of restoring a rotatable target, and a coating installation. Specifically, they relate to a rotatable target base device for sputtering installations, a rotatable target for sputtering installations, a method for producing a rotatable target for sputtering installations, a method of restoring a rotatable target for sputtering installations, and a coating installation.

### BACKGROUND OF THE INVENTION

Thin-film deposition of material on substrates may be accomplished in many ways, for example by evaporation or sputtering of the coating material in a vacuum chamber. Typical examples of thin-film deposition by sputtering are sputter deposition applications in solar wafer manufacturing or in semiconductor device production.

When operating a sputtering cathode, a plasma is established and ions of the plasma are accelerated onto a target of coating material to be deposited onto the substrates. This bombardment of the target results in ejection of atoms of the coating material, which accumulate as a deposited film on the substrate below the sputtering cathode. In order to obtain increased deposition rates, the use of magnetically enhanced cathodes has been proposed, which may also be referred to as magnetron sputtering.

Typical magnetically enhanced sputtering cathodes may include a flat target plate and an array of magnets mounted in a fixed position relative to the target plate. The magnetic field provided by the magnets establishes the path(s) or the region along which sputtering of the target plate materials takes place.

Other typical magnetically enhanced sputtering cathodes include a cylindrical rotatable tube, e.g. a backing tube, having a layer of the target material applied to the outer surface thereof. Magnetic means, which may include an array of magnets, are arranged inside the tube and provide a magnetic field. The tube is rotatable about its longitudinal axis so that it can be turned relative to the magnetic means to selectively bring different portions or segments of the target material on the outer surface thereof into position opposite to the magnets and within the magnetic field.

In the manufacture of rotatable magnetron sputtering cathodes, the target material may for example be applied by spraying onto the outer surface of a backing tube. Furthermore, the target material of typical sputtering targets may be depleted or consumed quickly, e.g. within a week.

### SUMMARY

In light of the above, a rotatable target base device according to claim 1, a rotatable target according to claim 10, a method for producing a rotatable target according to claim 14, a method of restoring a rotatable target according to claim 15, and a coating installation according to claim 17 are provided.

According to one embodiment, a rotatable target base device for sputtering installations is provided, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

According to another embodiment, a rotatable target for sputtering installations is provided, including a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part, the rotatable target base device having a solid target cylinder arranged on the lateral surface of the target base cylinder.

According to a further embodiment, a method of producing a rotatable target for sputtering installations is provided, including providing a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a solid target cylinder; and arranging the solid target cylinder on the lateral surface of the target base cylinder.

According to a yet further embodiment, a method of restoring a rotatable target for sputtering installations is provided, including providing a rotatable target for sputtering installations, the rotatable target including a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part, the rotatable target base device having a solid target cylinder arranged on the lateral surface of the target base cylinder and a target fixation means arranged on the at least one of the first and the second end regions of the target base cylinder; dismounting the fixation means from the at least one of the first and the second end regions; dismounting the solid target cylinder; providing another solid target cylinder; arranging the another solid target cylinder on the lateral surface of the target base cylinder; and installing the target fixation means at the at least one of the first and the second end regions.

According to an embodiment, a coating installation includes a rotatable target base device for sputtering installations, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Fig. 1 shows schematically a rotatable target including a rotatable target base device for sputtering installations according to one example of embodiments disclosed herein;

Figs. 2a and 2b show schematically a target base cylinder of the rotatable target base device of the example shown in Fig. 1;

Fig. 3a shows schematically a rotatable target including a rotatable target base device for sputtering installations according to one example of embodiments disclosed herein;

Fig. 3b shows schematically a target adjusting means of the rotatable target base device of the examples shown in Figs. 1, 2a and 3a;

Figs. 4a to 4c show schematically a cross sectional view of a retaining means in a closed position, a top view of the closed retaining means, and a top view of the opened retaining means, respectively, of the rotatable target base device of the example shown in Fig. 1;

Fig. 5 shows schematically a cross sectional view of a variation of the retaining means shown in Fig. 4 a to 4c, of the rotatable target base device of the example shown in Fig. 1;

Fig. 6 shows schematically a rotatable target including a rotatable target base device for sputtering installations according to a further example of embodiments disclosed herein;

Figs. 7a and 7b show schematically a top view and a cross sectional view of a further variation of the retaining means shown in Fig. 4 a to 4c, of the rotatable target base device of the example shown in Fig. 1.

It is contemplated that elements of one embodiment may be advantageously utilized in other embodiments without further recitation.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope, in the following the examples and embodiments of the rotatable target base device, of the rotatable target, of the method of producing a rotatable target, of the method of restoring a rotatable target, and of the coating installation are described referring to sputtering applications. Typically, the rotatable target base device includes vacuum-compatible materials and the coating installation is a vacuum coating installation. Typical applications of embodiments described herein are for example sputter deposition applications in the production of displays, such as LCD, TFT displays and OLED (Organic Light Emitting Diode), in solar wafer manufacturing and in semiconductor device production.

Within the following description of the drawings, the same reference numbers refer to the same components. Generally, only the differences with respect to the individual embodiments are described.

Without limiting the scope, in the following the target base cylinder of the rotatable target base device will e.g. be referred to as backing cylinder or backing tube. The rotatable target will e.g. include the backing cylinder and the solid target cylinder.

According to one embodiment, a rotatable target base device for sputtering installations is provided, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

The target base device is for example intended for concentrically arranging a solid target cylinder on the target base cylinder. Further, the solid target cylinder may be a hollow cylinder. By arranging the solid target cylinder on the target base cylinder, typically a rotatable target results. The rotatable target base device may be for a substantially horizontal mounting of a rotatable target in a sputtering installation. The rotatable target base device may also be for a substantially vertical mounting of a rotatable target. Typically, the lateral surface of the target base cylinder may be understood as the cylinder barrel or the mantle of the cylinder.

Embodiments disclosed herein allow for providing a target, which may be a solid target cylinder, on a backing cylinder, since access from at least one end of the backing cylinder is possible. This is due to the structure of the backing cylinder, in which at least one end region of the backing cylinder has a maximum outer diameter substantially equal to or less than the outer diameter of the middle part of the backing cylinder. Therefore, a cylindrical or tubular solid target having an inner diameter matching or being larger than the outer diameter of the middle part of the backing cylinder may be easily placed on the backing cylinder. The target may be designed for use as a bonded or non-bonded target, typically as a non-bonded target. Furthermore, in contrast to backing cylinders for sprayed targets, using embodiments described herein makes it possible to array a plurality of cylindrical or tubular solid targets or targets sleeves for bonded or non-bonded targets on a backing cylinder. Moreover, the rotatable target base device according to embodiments disclosed herein may be used repeatedly and the rotatable target may be restored by exchanging the cylindrical targets.

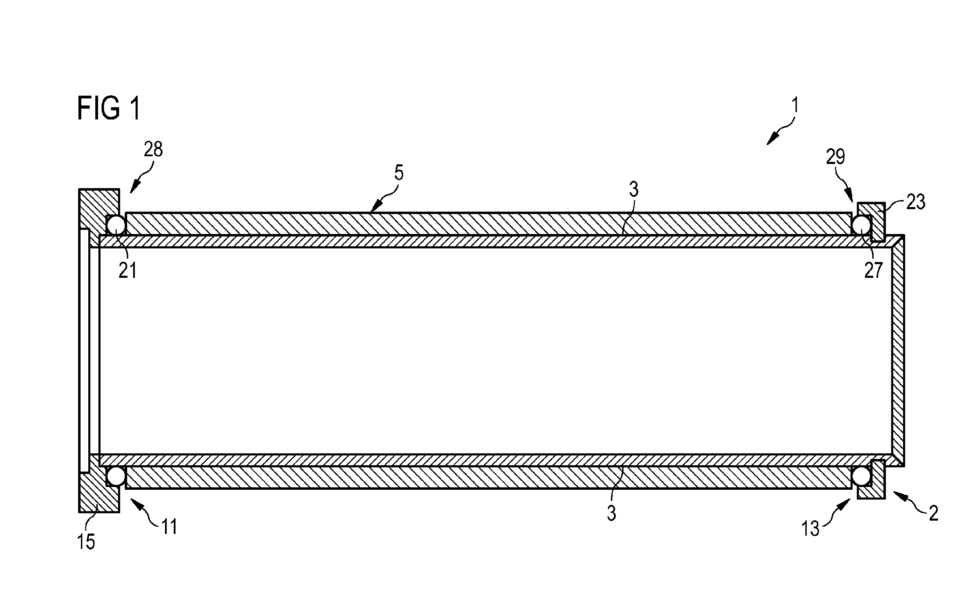

Figs. 1 shows schematically a rotatable target 1 for sputtering installations according to one example of embodiments disclosed herein. The rotatable target 1 typically includes a rotatable target base device 2 and a tubular solid target 5, also referred to herein as cylindrical target or target 5.

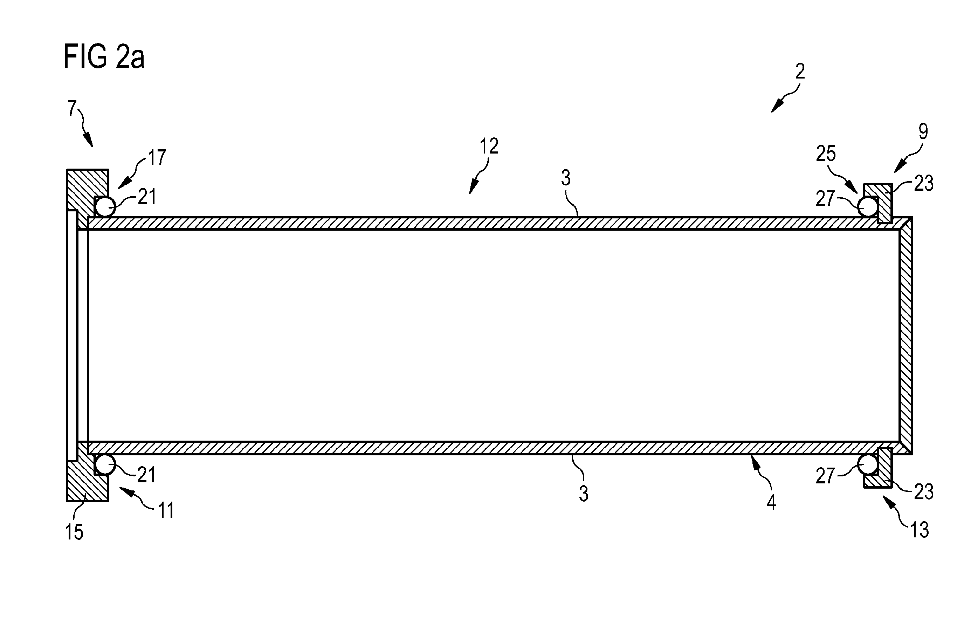

The rotatable target base device 2 of the rotatable target 1 illustrated in Fig. 1 is further schematically shown in Fig. 2a and includes a backing tube 4. In some examples of embodiments disclosed herein, at least one end region of the backing tube has a maximum outer diameter substantially equal to or less than an outer diameter of a middle part of the backing tube. In the present example, the rotatable target base device 2 may additionally include two target fixation means 11, 13.

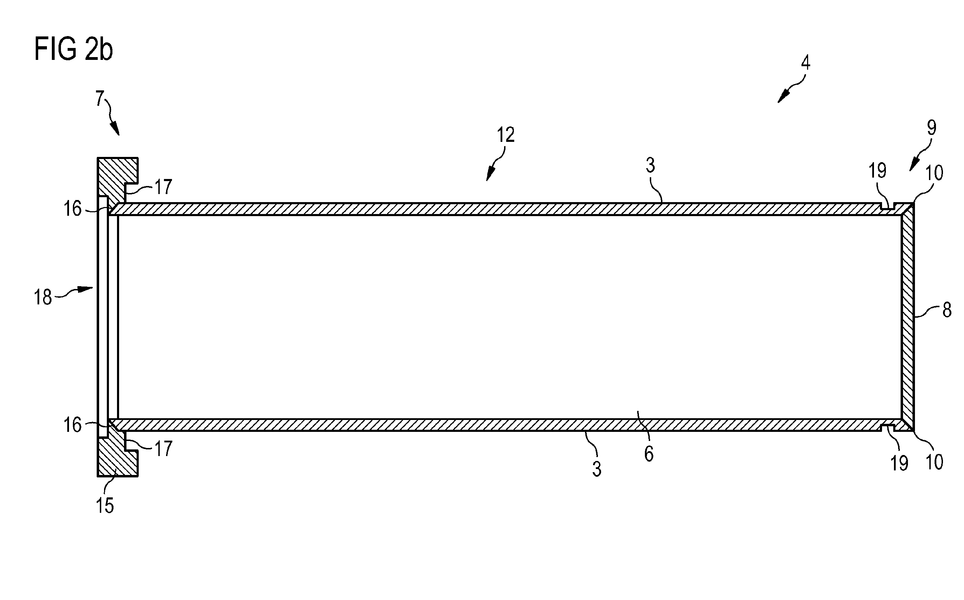

Backing tube 4 of the present example is schematically illustrated in Fig. 2b and has a middle part 12, a lateral surface 3, a first end region 7 and a second end region 9. In the present example, the second end region 9 has a maximum outer diameter substantially equal to or less than the outer diameter of the middle part 12. Furthermore, the backing tube 4 may be closed at the second end region 9 by a lid 8 at a welded joint 10. In addition, at the first end region 7, a connecting means for connecting the target base device to a target base support may be provided. In the present example, the connecting means is an annular flange 15, which may be welded at welding joint 16 to the first end region 7 of the backing tube 4. Thereby, backing tube 4 is provided with an opening 18. Furthermore, backing tube 4 may include an interior space 6 for containing at least one element selected from the group consisting of a magnet device and a cooling system.

In another example of embodiments disclosed herein, the rotatable target base device may include one ore more target fixation means, one of the target fixation means being adapted for being provided at the at least one of the first and the second end regions and being removable. In one example of embodiments disclosed herein, at least one target fixation means may be provided at at least one of the first and the second end regions. In a variation of this example, at least one of the target fixation means may be removable.

According to one example of embodiments disclosed herein, the first end region 7 and the second end region 9 of the backing tube 4 may each be provided with one of the target fixation means 11, 13. The target fixation means 11, 13 may include a retaining means and a target adjusting means. In the example illustrated in Figs. 1, 2a and 2b, the target fixation means 11 is provided at the first end region 7 and the target fixation means 13 is provided at the second end region 9 of backing tube 4. At least the target fixation means 13 may be removable from the backing tube 4.

As shown in Fig. 2b, flange 15 of the backing tube 4 may include an annular recess 17 adjacent to the lateral surface 3 of the backing tube 4. Flange 15 and annular recess 17 are parts of the target fixation means 11. Flange 15 serves as the retaining means of the target fixation means 11. Annular recess 17 acts as an adjusting recess of the target fixation means 11.

Further, as illustrated in Fig. 2b, backing tube 4 may include at the second end region 9 an annular recess 19 provided in the lateral surface 3. Annular recess 19 acts as a positioning recess and is part of the retaining means of the target fixation means 13.

Fig. 2a illustrates the backing tube 4 and the target fixation means 11 and 13 of the rotatable target base device 2 of the present example in an assembled state. The tubular solid target 5 of rotatable target 1 is not shown. For completion of the target fixation means 11, in annular recess 17 of flange 15 a coiled annular spring 21 may be provided. Furthermore, the assembled target fixation means 13 includes an annular locking means 23 positioned in the annular recess 19. Locking means 23 provides an annular recess 25 adjacent to the lateral surface 3. In the assembled state, the recess 25 is filled with a coiled annular spring 27.

In summary, in the present example, locking means 23 and recess 19 form the retaining means of target fixation means 13, whereas spring 27 is provided as target adjusting means of target fixation means 13. Further, in the present example, flange 15 is the retaining means of target fixation means 11 and spring 21 is the target adjusting means of target fixation means 11.

Fig. 1 shows the rotatable target 1 in an assembled state. The distance between flange 15 and locking means 23 positioned in the annular recess 19 is larger than the length of the tubular solid target 5. Target 5 is positioned at the lateral surface 3 of the backing tube 4 and disposed between springs 21 and 27 of the target fixation means 11 and 13, respectively. Hence, gaps 28 and 29 are provided between flange 15 and locking means 23, respectively, and the tubular solid target 5. Thereby, thermal expansion of the target 5 in parallel to the rotational axis, i.e. in the present example the longitudinal axis, of the backing tube 4 is possible and detrimental effects of such a thermal expansion are avoided. Because of the spring tensions of springs 21 and 27, target 5 is aligned or even centered on the backing tube 4. Thereby, an optimal position of the tubular solid target 5 in parallel to the rotational axis of the rotatable target 1 may be achieved. The springs 21 and 27 hold the target 5 in a fixed position, even though gaps 28 and 29 are provided.

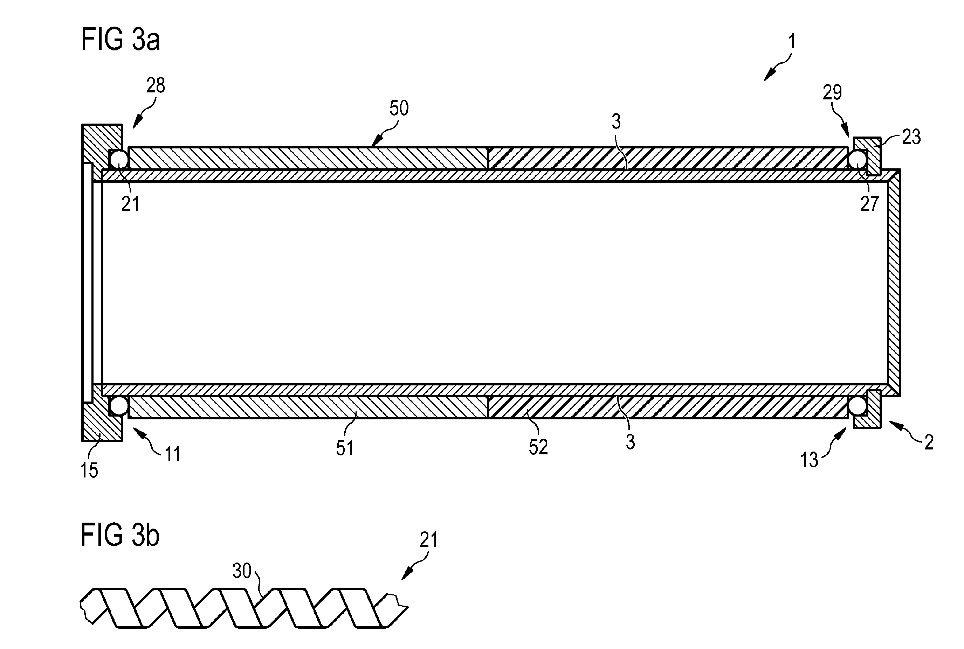

At least one of springs 21 and 27 may include at least one material selected from the group of electrically conductive material, metal, and stainless steel. Typically, springs 21 and 27 may be made from a flat metal stripe, which is coiled in itself. Hence, springs 21 and 27 may provide an electrical contact. This may typically be desirable for providing a defined electrical potential at least between flange 15 and the tubular solid target 5 shown in Fig. 1 via spring 21. Fig. 3a illustrates another example of rotatable target 1 of embodiments disclosed herein, having a tubular solid target 50 including two adjacent tubular pieces 51 and 52. In such a case, each piece 51 and 52 may be provided with a defined electrical potential by the respective adjacent spring 21, 27.

As an example of annular coiled springs 21 and 27, in Fig. 3b spring 21 is illustrated. In the present example, spring 21 is made from a flat metal stripe 30, which is coiled in itself. The resulting coil of the flat metal stripe 30 is formed as a ring (not shown) having a size and a diameter suitable for filling the recess 17 of flange 15. Accordingly, the diameter of spring 27 is sized to suitably fill the recess 19 of backing tube 4. As depicted in Fig. 3b, at the outer circumference of spring 21, flat faces of spring 21 are positioned. Therefore, when spring 21 is made from electrically conductive material, the intensity of the electrical contact between the spring and the adjacent flange 15 and the target 5 is increased.

In one example of embodiments disclosed herein, the locking means may include at least one element selected from the group consisting of a clamp, a clamp ring, a plurality of segmented clamp elements adapted for being closed to a clamp, a plurality of annular segmented clamp elements adapted for being closed to a clamp ring, two semicircular clamp elements, a target adjusting means contact element which includes the adjusting recess, and a target adjusting means contact ring which includes the adjusting recess. Most typically, the annular segmented clamp elements may be semiannular, also referred to herein as semicircular. Generally, annular segmented elements have lengths and radii such that, when longitudinally aligned one with each other and viewed, an annulus is seen by the viewer.

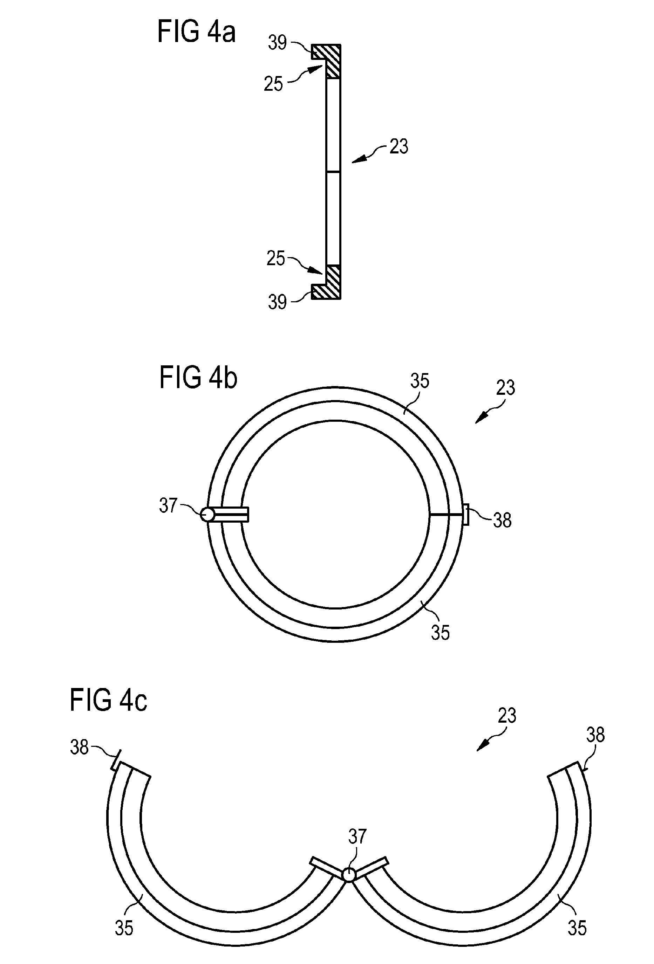

Figs. 4a, 4b and 4c illustrate an example of locking means 23 of the target fixation means 13. As shown in Fig. 4c, locking means 23 may include two semicircular elements 35, which are hinged to each other by a hinge 37 and may be secured when closed by a fastener 38, which e.g. may be formed as a catch. This structure allows closing the two semicircular elements 35 of the locking means around the backing tube 4 while positioning the locking means in the annular recess 19. Fig. 4b shows locking means 23 in a closed state. As illustrated in Fig. 4a showing a cross sectional view of locking means 23 in a closed state, locking means 23 has at the outermost circumference thereof an annular lateral protrusion 39. Thereby, the annular recess 25, shown in Fig. 2a as containing the spring 27, is provided, when mounting the locking means 23 at recess 19 of backing tube 4. The width and the inner diameter of closed locking means 23 are suitably chosen, in order to provide a good match of the locking means 23 and the recess 19. For instance, the width at the inner diameter of locking element 23 is slightly smaller than the width of recess 19, and the inner diameter of locking means 23 it is slightly larger than the diameter of the bottom of recess 19.

In other examples of embodiments, the target fixation means includes a locking means having a target adjusting means contact ring and a clamp ring.

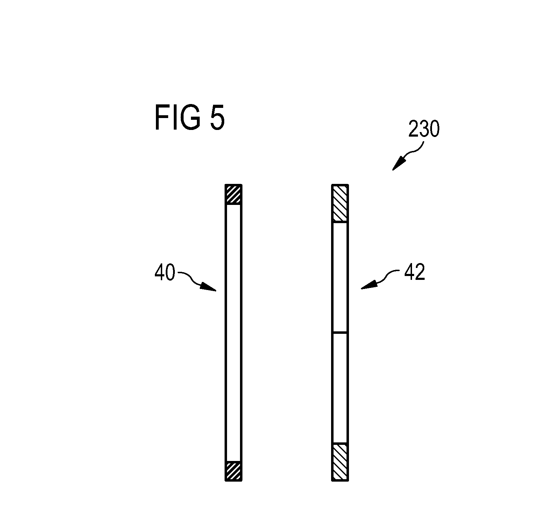

As shown in Fig. 5, the target fixation means 13 may include a locking means 230 having two ring structures, e.g. a spring contact ring 40, and a secure ring 42. Secure ring 42 has a structure similar to the structure of locking means 23, i.e. it includes two semicircular elements which are hinged to each other and may be closed around backing tube 4 in recess 19. The difference between secure ring 42 and locking means 23 described above is that secure ring 42 has no annular protrusion 39. Instead of annular protrusion 39, locking means 230 includes spring contact ring 40 having a structure resulting in protrusion 39 when contact ring 40 is adjoined to secure ring 42. That means, the outer diameters of spring contact ring 40 and secure ring 42 may be identical, whereas the inner diameter of spring contact ring 40 is larger that the inner diameter of secure ring 42. The difference of the inner diameters of spring contact ring 40 and secure ring 42 is such that in an assembled state of rings 40, 42 and the backing tube 4, recess 25 shown in Fig. 2a is formed, which may receive spring 27.

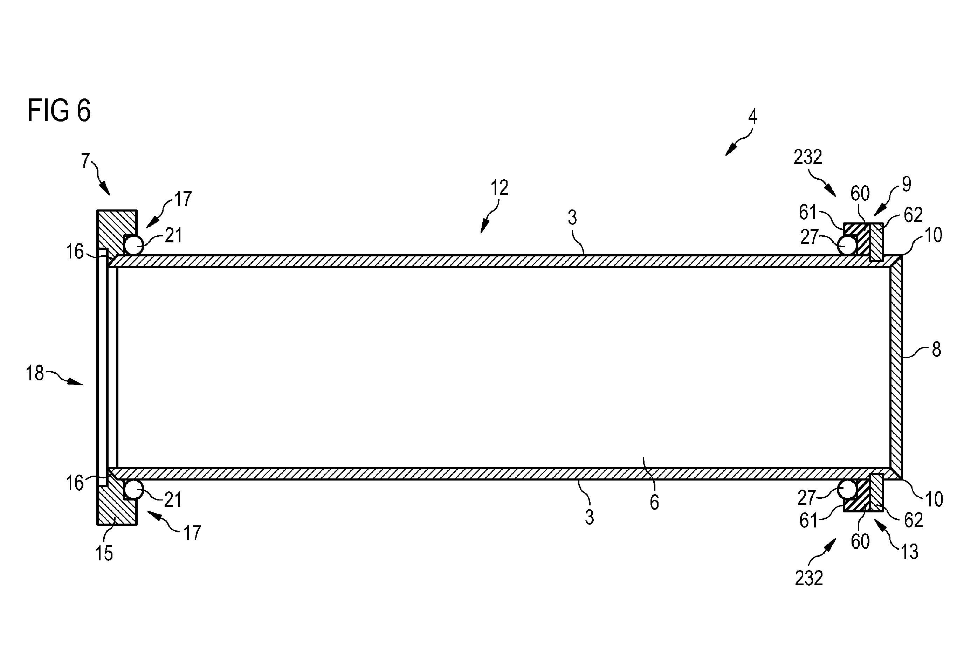

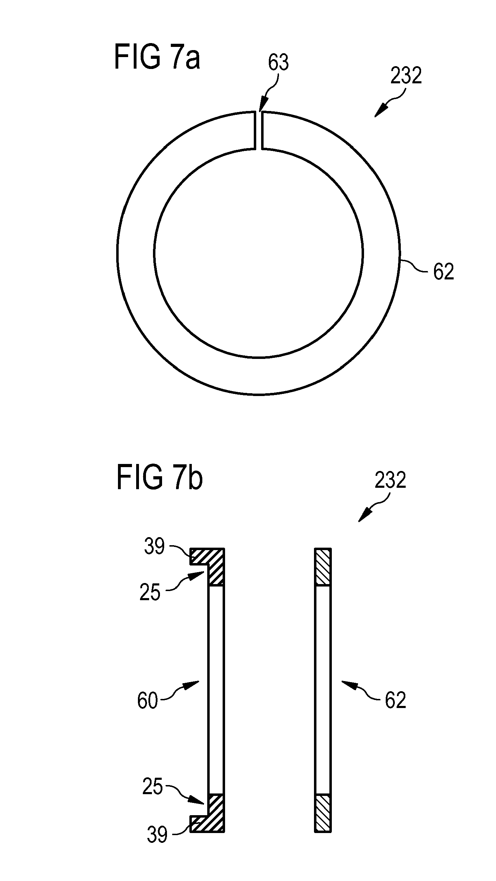

According to one example, as illustrated in Figs. 6, 7a and 7b, the target fixation means 13 may include a locking means 232 having a flange 60 as a target adjusting means contact ring and a clamp ring 62. Fig. 6 illustrates the backing tube 4 and the target fixation means 11 and 13 of the rotatable target base device 2 of the present example in an assembled state. The tubular solid target 5 of rotatable target 1 is not shown. As illustrated in Fig. 6, when locking means 232 is mounted at backing tube 4, clamp ring 62 is concentrically provided in recess 19. Further, flange 60 is concentrically positioned adjacent to clamp ring 62 and faces the middle part 12 of the backing tube 4.

A top view of clamp ring 62 of the present example is shown in Fig. 7a. Clamp ring 62 may e.g. be formed of a vacuum compatible metallic material and has an annular ring structure including a gap 63. The width and the inner diameter of clamp ring 62 are suitably chosen, in order to provide a good match of clamp ring 62 and the recess 19 of the backing tube 4. Clamp ring 62 has an intrinsic tension and exerts a clamping force, when mounted in recess 19. Furthermore, the intrinsic tension allows for a back formation of the clamp ring 62 when gap 63 is expanded using a tool and released again. Cross sectional views of clamp ring 62 and flange 60 are shown in Fig. 7b. Flange 60 has an inner diameter substantially equal to or slightly larger than the outer diameter of the lateral surface 3 of the backing tube 4. Further, flange 60 has at the outermost circumference thereof the annular lateral protrusion 39, like locking means 32. Thereby, the annular recess 25, shown in Fig. 6 as containing spring 27, can be provided, when mounting the locking means 232 at recess 19 of backing tube 4. In one variation of this example, gap 63 may be closed and clamp ring 62 may be secured by a fastener, such as fastener 38 formed as a catch and mentioned above referring to Fig. 4b.

In examples of embodiments disclosed herein, the inner diameter of the solid target cylinder may be substantially equal to or larger than the outer diameter of the middle part of the target base cylinder. Typically, the target 5, 50 may have an outer diameter of about 100 mm to about 200 mm, more typically of about 130 mm to about 170 mm, most typically of about 150 mm to about 160 mm. The inner diameter of the target 5, 50 may be in the range of about 80 mm to about 180 mm, more typically of about 110 mm to about 150 mm, most typically of about 130 to about 140 mm. The thickness of the target may be in the range of about 3 mm to about 30 mm, most typically about 20 mm. Typically, the length of the target 5 may be in a range of about 240 mm to about 1540 mm, more typically of about 440 mm to about 1340 mm, most typically about 440 mm to about 540 mm. The outer diameter of the backing tube 4 in the middle part may be in the range of about 80 mm to about 180 mm, more typically of about 110 mm to about 150 mm, most typically of about 130 to about 140 mm. The inner diameter of backing tube 4 may typically be in the range of about 60 mm to 160 mm, more typically about 90 to about 130 mm, most typically about 110 mm to 120 mm. The length of the backing tube 4 may be in a range of about 300 mm to about 1600 mm, more typically of about 500 mm to about 1400 mm, most typically about 500 mm to about 600 mm. Typically, the inner diameter of the target 5, 50 and the outer diameter of the backing tube 4 are chosen such that the spacing between the inner surface of the target 5, 50 and the lateral surface 3 of the backing tube 4 is equal to or less than 0.7 mm, in order to provide a desired heat transfer between the target and the backing tube. In some examples of embodiments disclosed herein, the outer and/or inner diameters of the middle part of the backing tube 4 are substantially constant over the length of the middle part 12. Further, in some examples of embodiments disclosed herein, the outer and/or inner diameters of the target 5, 50 are substantially constant over the length of the target 5, 50.

As an example of a target material used in embodiments disclosed herein, the target 5 may include Silicon, e.g. 5N quality, which may be doped with Boron, e.g. Z-600.

Typically, examples of embodiments disclosed herein are suitable for a substantially horizontal mounting, or, in relation to a horizontal line, even a somewhat inclined mounting of the rotatable target 1, since e.g. the springs 21 and 27 provide for a reliable alignment or centering of the tubular solid target 5.

According to a further embodiment, a method of producing a rotatable target for sputtering installations is provided, including the steps of providing a rotatable target base device for sputtering installations, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a solid target cylinder; and arranging the solid target cylinder on the lateral surface of the target base cylinder. Optionally, the method may include, after the step of arranging the solid target cylinder, a step of installing at at least one of the first and the second end regions of the target base cylinder a target fixation means.

Further, the solid target cylinder may be a hollow cylinder. The solid target cylinder may be arranged concentrically on the target base cylinder. Typically, by combining the solid target cylinder and the target base cylinder according to above further embodiment, the rotatable target is formed. The rotatable target may be for substantially horizontally mounting a sputtering target in a sputtering installation.

In one example of a method of embodiments described herein, backing tube 4 shown in Fig. 2b is provided. Then, spring 21 is concentrically positioned on backing tube 4 at the second end region 9 and moved from the second end region 9 to the first end region 7 and placed in recess 17. Thereafter, tubular solid target 5 is concentrically placed on the second end region 9, moved in parallel to the central axis, i.e. in the present example a longitudinal axis, of the backing tube 4 and placed in contact to spring 21. Then, spring 27 is concentrically placed on backing tube 4 in contact to target 5. Subsequently, locking means 23 is concentrically positioned in recess 19, the protrusion 39 facing target 5 and spring 27 filling recess 25, and closed around backing tube 4. As a result, tubular solid target 5 is aligned or centered between springs 21 and 27, providing the rotatable target 1 shown in Fig. 1. Gaps 28 and 29, which are variable because of springs 21 and 27, allow for thermal expansion of the target material in parallel to the rotational axis of the rotatable target 1. Spring 21, which is made of electrically conductive material, provides a defined potential of the target 5.

In a variation of the above example, instead of locking means 23, the locking means 230 may be used. In this case, the above method is adapted as follows: After placing the spring 27 in contact to the target 5, the spring contact ring 40 is concentrically arranged on the backing tube 4 in contact to spring 27. Then, secure ring 42 is arranged in recess 19 and closed around backing tube 4.

In a further variation of the above example of a method of embodiments, instead of locking means 23, the locking means 232 may be provided. In this case, the above method is adapted as follows: After placing spring 27 in contact to the target 5, flange 60 is concentrically arranged on the backing tube 4, the protrusion 39 facing the target and encompassing spring 27. Then, gap 63 of clamp ring 62 is expanded, e.g. using a tool, and clamp ring 62 is arranged in recess 19 of backing tube 4. Gap 63 is released and clamp ring 62 is closed around backing tube 4.

As mentioned above, the second end region 9 of backing tube 4 has a maximum outer diameter substantially equal to or less than the outer diameter of the middle part. Therefore, tubular solid target 5, which has an inner diameter substantially equal to or larger than the outer diameter of the middle part of the backing tube, can be placed on the backing tube 4 by concentrically arranging it on the second end region 9 and moving or pushing it on the backing tube 4 in parallel to the rotational axis, i.e. in the present example the longitudinal axis, of the backing tube. Furthermore, this procedure may also be used when restoring the rotatable target 1 for replacing a depleted target 5. For instance, a replacement may be performed by dismounting the target fixation means 13 from the rotatable target 1 as shown in Fig. 1, removing the target 5, concentrically arranging another target 5 on the backing tube 4, and mounting the target fixation means 13 again at the backing tube 4.

Hence, according to a yet further embodiment, a method of restoring a rotatable target for sputtering installations is provided, including providing a rotatable target for sputtering installations, the rotatable target including a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part, the rotatable target base device having a solid target cylinder arranged on the lateral surface of the target base cylinder and a target fixation means arranged on the at least one of the first and the second end regions; dismounting the target fixation means from the at least one of the first and the second end regions of the target base cylinder; dismounting the solid target cylinder; providing another solid target cylinder; arranging the another solid target cylinder on the lateral surface of the target base cylinder; and installing the target fixation means at the at least one end region of the target base cylinder.

Further, the solid target cylinder may be a hollow cylinder. The solid target cylinder may be arranged concentrically on the target base cylinder. The rotatable target may be for substantially horizontally mounting a sputtering target in a sputtering installation. Typically, by treating and combining the solid target cylinder and the target base cylinder according to above yet further embodiment, the rotatable target is restored. This is possible using the rotatable target base device and the rotatable target, respectively, according to embodiments disclosed herein, since at at least one side of the target base cylinder, a collar or clamping collar, e.g. the target fixation means, for holding the target cylinder on the target base cylinder may be removed. Moreover, in case of a horizontally held rotatable target connected to a target base support, e.g. a bearing and/or a drive, at only one side, the target fixation means can be removed at the side without target base support for exchanging the target cylinder.

In variations of above examples of the rotatable target 1, of the target base device and of the methods, only one target adjusting means of the target fixation means, e.g. only one of springs 21 and 27, may be provided at the backing tube 4 for positioning, e.g. aligning or centering, the tubular solid target thereon.

Moreover, in other variations of above examples of the rotatable target 1, of the target base device, and of the methods, instead of flange 15 including the recess 17, as a connecting means to a target base support, a flange without recess 17 may be provided. In addition, a second target fixation means 13 may be provided. The second target fixation means may be located adjacent to the flange between tubular solid target 5 and the flange. To this end, a recess, which corresponds to recess 19, may be provided in the lateral surface 3 between tubular solid target 5 and the flange. In this case, the second target fixation means 13 may be mirror inversely arranged as compared to the first target fixation means 13 positioned at the second end region 9.

Embodiments disclosed herein allow for providing a cylindrical target, which may be a solid target material tube, on a backing cylinder, e.g. a backing tube, since access from at least one end of the backing cylinder is possible. This is due to the structure of the backing cylinder, in which at least one end region of the backing cylinder has a maximum outer diameter substantially equal to or less than an outer diameter of the middle part of the backing cylinder. Therefore, a cylindrical or tubular solid target having an inner diameter matching an outer diameter of the middle part of the backing cylinder may be easily placed on the backing cylinder via the end region having a maximum outer diameter substantially equal to or less than an outer diameter of the middle part of the backing cylinder. Furthermore, according to embodiments disclosed herein, the at least one end region may be provided with a removable target fixation means, which may be removed when placing the cylindrical target on the backing cylinder. The target may be designed for use as a bonded or non-bonded target, typically as a non-bonded target. If the target is used as a non-bonded target, as a result of embodiments disclosed herein, expensive bonding of a solid target to a backing cylinder may be avoided, the more so as use of extensive bonding material is not required for fixation of the target on the backing cylinder. In other examples, a solid target may be provided on a backing tube of the sputtering cathode by bonding, which may require bonding material.

Furthermore, since, according to some examples of embodiments, one or more target fixation means may be provided which allow for at least one gap between the cylindrical solid target and the target fixation means, the thermal expansion coefficient between the backing cylinder material and the target material may be different. In addition, in examples of embodiments, which include the target fixation means, the target may be fixed to the backing cylinder, or even centered or aligned on the backing cylinder in a desired position.

According to one embodiment, a rotatable target base device for sputtering installations is provided, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

According to a modification of above one embodiment, the rotatable target base device may include one ore more target fixation means, one of the target fixation means being adapted for being provided at the at least one of the first and the second end regions and being removable.

According to a modification of any of above one embodiment and modification thereof, the rotatable target base device further includes one ore more target fixation means, one of the target fixation means being provided at the at least one of the first and the second end regions, wherein at least the target fixation means provided at the at least one of the first and the second end regions is removable.

According to a modification of any of above one embodiment and modifications thereof, the target fixation means includes a retaining means and a target adjusting means.

According to a modification of any of above one embodiment and modifications thereof, the target fixation means includes an adjusting recess provided in the retaining means and adapted for at least partially containing the target adjusting means.

According to a modification of any of above one embodiment and modifications thereof, the first end region is provided with a connecting means adapted for connecting the target base device to a target base support, the connecting means being optionally annular.

According to a modification of any of above one embodiment and modifications thereof, the connecting means is a flange provided at the first end region of the target base cylinder.

According to a modification of any of above one embodiment and modifications thereof, the first end region is adapted for being provided with a first end target fixation means of the target fixation means, the connecting means forming the retaining means of the first end target fixation means.

According to a modification of any of above one embodiment and modifications thereof, the second end region has a maximum outer diameter substantially equal to or less than an outer diameter of the middle part and is adapted for being provided with a second end target fixation means of the target fixation means.

According to a modification of any of above one embodiment and modifications thereof, the retaining means of the second end target fixation means includes a positioning recess provided in the lateral surface of the target base cylinder and a locking means, the locking means being adapted for partially filling the positioning recess, the locking means providing the adjusting recess.

According to a modification of any of above one embodiment and modifications thereof, the locking means includes at least one element selected from the group consisting of a clamp, a clamp ring, a plurality of segmented clamp elements adapted for being closed to a clamp, a plurality of annular segmented clamp elements adapted for being closed to a clamp ring, two semicircular clamp elements, a target adjusting means contact element which includes the adjusting recess, and a target adjusting means contact ring which includes the adjusting recess.

According to a modification of any of above one embodiment and modifications thereof, the target adjusting means is at least one element selected from the group consisting of a spring, a coiled spring, an annular spring, an annular coiled spring, a spring made from a flat metal stripe, a coiled spring made from a flat metal stripe, an annular spring made from a flat metal stripe, and an annular coiled spring made from a flat metal stripe.

According to a modification of any of above one embodiment and modifications thereof, the target adjusting means includes at least one material selected from the group of electrically conductive material, metal, and stainless steel.

According to a modification of any of above one embodiment and modifications thereof, the target base cylinder includes an interior space for containing at least one element selected from the group consisting of a magnet device and a cooling system.

According to another embodiment, a rotatable target for sputtering installations includes a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part, the rotatable target base device having a solid target cylinder arranged on the lateral surface of the target base cylinder.

According to a modification of above another embodiment, the rotatable target base device includes one ore more target fixation means, one of the target fixation means being provided at the at least one of the first and the second end regions, wherein at least the target fixation means provided at the at least one of the first and the second end regions is removable.

According to a modification of any of above another embodiment and modification thereof, the solid target cylinder is at least one element selected from the group consisting of a tubular solid target cylinder and a solid target cylinder, the tubular solid target cylinder and the solid target cylinder having an inner diameter substantially equal to or larger than the outer diameter of the middle part of the target base cylinder.

According to a modification of any of above another embodiment and modifications thereof, the solid target cylinder is tubular.

According to a modification of any of above another embodiment and modifications thereof, the solid target cylinder is located between the first and the second end region, and is adjusted by at least one of the target fixation means by being positioned adjacent to at least one target adjusting means.

According to a modification of any of above another embodiment and modifications thereof, the target adjusting means of the target fixation means provides a gap between the retaining means and the solid target cylinder.

According to a further embodiment, a method of producing a rotatable target for sputtering installations includes providing a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part; providing a solid target cylinder; and arranging the solid target cylinder on the lateral surface of the target base cylinder.

According to a modification of above further embodiment, the step of arranging includes concentrically placing the solid target cylinder on the at least one of the first and the second end regions; and moving the solid target cylinder in parallel to a central axis of the target base cylinder.

According to a modification of any of above further embodiment and modification thereof, the method includes after the step of arranging the solid target cylinder a step of installing at the at least one of the first and the second end regions a target fixation means.

According to a yet further embodiment, a method of restoring a rotatable target for sputtering installations is provided, including providing a rotatable target for sputtering installations, the rotatable target including a rotatable target base device, the rotatable target base device being adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part, the rotatable target base device having a solid target cylinder arranged on the lateral surface of the target base cylinder and a target fixation means arranged on the at least one end region; dismounting the target fixation means from the at least one end region of the target base cylinder; dismounting the solid target cylinder; providing another solid target cylinder; arranging the another solid target cylinder on the lateral surface of the target base cylinder; and installing the target fixation means at the at least one end region of the target base cylinder.

According to an embodiment, a coating installation includes a rotatable target base device for sputtering installations, wherein the target base device is adapted for receiving thereon a solid target cylinder, the rotatable target base device including a target base cylinder having a lateral surface, a middle part, a first end region and a second end region opposite to the first end region, wherein at least one of the first and the second end regions has a maximum outer diameter substantially equal to or less than an outer diameter of the middle part.

According to another embodiment, a coating installation includes the rotatable target base device for sputtering installations of any of above one embodiment and modifications thereof.

According to a modification of any of above embodiments and modifications thereof, the inner diameter of the solid target cylinder may be substantially equal to or larger than the outer diameter of the middle part of the target base cylinder.

According to a modification of any of above embodiments and modifications thereof, the rotatable target base device is for a substantially horizontal mounting of a rotatable target in a sputtering installation.

According to a modification of any of above embodiments and modifications thereof, the target base cylinder is a tubular base cylinder, and/or the solid target cylinder is tubular.

According to a modification of any of above embodiments and modifications thereof, at least one of the adjusting recess, the positioning recess, and the locking means is annular.

According to a modification of any of above embodiments and modifications thereof, the connecting means is annular.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A rotatable target base device for sputtering installations, wherein the target base device is adapted for receiving thereon a solid target cylinder, the rotatable target base device comprising
a target base cylinder (4) having a lateral surface (3), a middle part (12), a first end region (7) and a second end region (9) opposite to the first end region,
wherein at least one of the first and the second end regions has a maximum outer diameter substantially equal to or less than an outer diameter of the middle part.

2. The rotatable target base device of claim 1, further comprising one or more target fixation means (11, 13), one of the target fixation means (13) being adapted for being provided at the at least one of the first and the second end regions and being removable.

3. The rotatable target base device of claim 2, wherein the target fixation means comprises a retaining means (15; 23; 40, 42) and a target adjusting means (21; 27); and/or
wherein the target fixation means comprises an adjusting recess (17; 25) provided in the retaining means and adapted for at least partially containing the target adjusting means.

4. The rotatable target base device of any of claims 1 to 3,
wherein the first end region is provided with a connecting means (15) adapted for connecting the target base device to a target base support, the connecting means optionally being a flange provided at the first end region of the target base cylinder, and/or
wherein the first end region is adapted for being provided with a first end target fixation means of the target fixation means, the connecting means forming the retaining means of the first end target fixation means.

5. The rotatable target base device of any of claims 3 to 4, wherein the second end region has a maximum outer diameter substantially equal to or less than an outer diameter of the middle part and is adapted for being provided with a second end target fixation means of the target fixation means, and/or wherein the retaining means of the second end target fixation means comprises a positioning recess (19) provided in the lateral surface of the target base cylinder and a locking means (23; 42), the locking means being adapted for partially filling the positioning recess, the locking means providing the adjusting recess.

6. The rotatable target base device of any of claims 1 to 5, wherein the target base cylinder is a tubular base cylinder, and/or wherein at least one of the adjusting recess, the positioning recess, the locking means, and the connecting means is annular.

7. The rotatable target base device of claim 5 or 6, wherein the locking means comprises at least one element selected from the group consisting of a clamp, a clamp ring, a plurality of segmented clamp elements adapted for being closed to a clamp, a plurality of annular segmented clamp elements adapted for being closed to a clamp ring, two semicircular clamp elements, a target adjusting means contact element (40) which includes the adjusting recess, and a target adjusting means contact ring (40) which includes the adjusting recess.

8. The rotatable target base device of any of claims 3 to 7, wherein the target adjusting means is at least one element selected from the group consisting of a spring, a coiled spring, an annular spring, an annular coiled spring, a spring made from a flat metal stripe, a coiled spring made from a flat metal stripe, an annular spring made from a flat metal stripe, and an annular coiled spring made from a flat metal stripe, and /or
wherein the target adjusting means comprises at least one material selected from the group of electrically conductive material, metal, and stainless steel.

9. The rotatable target base device of any of claims 1 to 8, wherein the target base cylinder comprises an interior space for containing at least one element selected from the group consisting of a magnet device and a cooling system.

10. A rotatable target for sputtering installations, comprising a rotatable target base device according to any of claims 1 to 9, the rotatable target base device having a solid target cylinder arranged on the lateral surface of the target base cylinder.

11. The rotatable target for sputtering installations of claim 10, the rotatable target base device having at least one of the target fixation means installed at the at least one of the first and the second end regions,
wherein at least the target fixation means provided at the at least one of the first and the second end regions is removable, and/or wherein the inner diameter of the solid target cylinder is substantially equal to or larger than the outer diameter of the middle part of the target base cylinder.

12. The rotatable target of claim 10 or 11, wherein the solid target cylinder is tubular, and/or is located between the first and the second end region, and /or is adjusted by at least one of the target fixation means by being positioned adjacent to at least one of the target adjusting means.

13. The rotatable target of claim 10 to 12, wherein the target adjusting means of the target fixation means provides a gap between the retaining means and the solid target cylinder.

14. A method of producing a rotatable target for sputtering installations, comprising
providing a rotatable target base device according to any of claims 1 to 9, providing a solid target cylinder, and
arranging the solid target cylinder on the lateral surface of the target base cylinder,
optionally comprising after the step of arranging the solid target cylinder a step of installing at the at least one of the first and the second end regions of the target base cylinder a target fixation means.

15. A method of restoring a rotatable target for sputtering installations, comprising
providing a rotatable target according to any of claims 10 to 13,
the rotatable target base device having a solid target cylinder arranged on the lateral surface of the target base cylinder and a target fixation means arranged on the at least one of the first and the second end regions of the target base cylinder;
dismounting the target fixation means from the at least one of the first and the second end regions;
dismounting the solid target cylinder;
providing another solid target cylinder;
arranging the another solid target cylinder on the lateral surface of the target base cylinder;
and installing the target fixation means at the at least one of the first and the second end regions.

16. The method according to any of claims 14 and 15, wherein in the step of arranging, the solid target cylinder is concentrically arranged on the target base cylinder.

17. A coating installation comprising a rotatable target base device according to any of claims 1 to 9.
